(19) Europäisches Patentamt / European Patent Office / Office européen des brevets

(11) **EP 2 443 468 B1**

(12) **EUROPEAN PATENT SPECIFICATION**

(45) Date of publication and mention
of the grant of the patent:
**16.10.2013 Bulletin 2013/42**

(21) Application number: **09779790.6**

(22) Date of filing: **16.06.2009**

(51) Int Cl.:
*G01R 31/317* ^(2006.01)      *G01R 31/28* ^(2006.01)
*H02M 7/483* ^(2007.01)      *H02M 7/49* ^(2007.01)
*G01R 31/42* ^(2006.01)

(86) International application number:
**PCT/EP2009/057447**

(87) International publication number:
**WO 2010/145692 (23.12.2010 Gazette 2010/51)**

(54) **AN ARRANGEMENT FOR TESTING A SWITCHING CELL**

VORRICHTUNG ZUM TESTEN EINER SCHALTZELLE

AGENCEMENT POUR LE TEST D'UNE CELLULE DE COMMUTATION

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(43) Date of publication of application:
**25.04.2012 Bulletin 2012/17**

(73) Proprietor: **ABB Technology AG
8050 Zürich (CH)**

(72) Inventor: **ASPLUND, Gunnar
S-171 60 Solna (SE)**

(74) Representative: **Ahrengart, Kenneth
ABB AB
Intellectual Property
Ingenjör Bååths Gata 11
721 83 Västerås (SE)**

(56) References cited:
**WO-A1-2007/023064      DE-A1- 10 103 031
JP-A- 2001 025 257      US-A1- 2005 083 716**

## Description

TECHNICAL FIELD OF THE INVENTION AND BACKGROUND ART

The present invention relates to a test arrangement for testing the function of a semiconductor device of turn-off type configured to be a component of a cascaded multi-level converter, as well as a method for performing such testing.

A cascaded multi-level converter may be used in all kinds of situations, in which direct voltage is to be converted into alternating voltage and conversely, in which examples of such uses are in stations of HVDC-plants (High Voltage Direct Current), in which direct voltage is normally converted into a three-phase alternating voltage or conversely, or in so-called back-to-back stations in which alternating voltage is firstly converted into direct voltage and this is then converted into alternating voltage, as well as in SVCs (Static Var Compensator), in which the direct voltage side consists of capacitors hanging freely. However, the present invention is not restricted to these applications, but other applications are also conceivable, such as in different types of drive systems for machines, vehicles etc.
A cascaded multi-level converter may comprise any number of phase legs, but it has normally three phase legs for having a three-phase alternating voltage on the alternating voltage side thereof.

A cascaded multi-level converter is known through for example DE 101 03 031 A1 and WO 2007/023064 A1, where a specific cascaded two-level converter is disclosed. The converter may also be called a multi-cell converter or a M2LC. Reference is made to these publications for the functioning of a converter of this type. The switching cell of such a converter has on one hand at least two semiconductor assemblies connected in series, each semiconductor assembly having a semiconductor device of turn-off type and a free-wheeling diode connected in anti-parallel therewith, and on the other an energy storing capacitor as well as two terminals. The switching cells are configured to be connected through said terminals to each other for forming a series connection any thereby a converter phase leg connecting to opposite poles of a direct voltage side of the converter. A mid point of said series connection of switching cells forms a phase output and is configured to be connected to an alternating voltage side of the converter. Each switching cell is configured to obtain two switching states by control of said semiconductor devices of each switching cell, namely a first switching state and a second switching state, in which the voltage across the energy storing capacitor and a zero voltage, respectively, is applied across the two terminals of the switching cell, for obtaining a determined alternating voltage on the phase output. The series connection of switching cells includes inductance means.

The switching cells of a cascaded multi-level converter may have other appearances than those shown in said publications and it is for instance possible that each switching cell has more than one energy storing capacitors, as long as it is possible to control the switching cells to be switched between the two states mentioned above.

Furthermore, the present invention is primarily, but not exclusively, directed to the testing of semiconductor devices of turn-off type configured to be a component of a cascaded multi-level converter with the converter being configured to transmit high power. For this reason, the case of transmitting high power will mainly be discussed hereinafter for illuminating but not in any way restricting the invention thereto. When such a cascaded multi-level converter is used to transmit high powers this also means that high voltages are handled, and the voltage of the direct voltage side of the converter is determined by the voltages across said energy storing capacitors of the switching cells. This means that a comparatively high number of such switching cells are to be connected in series for a high number of semiconductor devices, i.e. said semiconductor assemblies are to be connected in series in each said switching cell, and a cascaded multi-level converter of this type is particularly interesting when the number of the switching cells in said phase leg is comparatively high. A high number of such switching cells connected in series means that it will be possible to control these switching cells to change between said first and second switching state and by that already at said phase output obtain an alternating voltage being very close to a sinusoidal voltage. This may be obtained already by means of substantially lower switching frequencies than typically used in known cascaded multi-level converters of the type shown in Fig 1 in DE 101 03 031 A1 having switching cells with at least one semiconductor device of turn-off type and at least one free-wheeling diode connected in anti-parallel therewith. This makes if possible to obtain substantially lower losses and also considerably reduces problems of filtering and harmonic currents and radio interferences, so that equipment therefor may be less costly.

It is of course important to test the semiconductor devices and thereby ensure the proper function of such switching cells, before delivering and erecting a cascaded multi-level converter of this type in for instance a converter station of a plant for transmitting electric power. It is then also necessary to know that the semiconductor devices will function as desired under conditions being identical to or at least comparable with the conditions prevailing when the semiconductor device and its corresponding switching cell are built in into the cascaded multi-level converter for which it is intended. However, it would not be feasible to construct and assemble an entire such cascaded multi-level converter and control the switching cells thereof for testing the proper function of a semiconductor device thereof.

Thus, it would be highly desired to have a test arrangement for testing the function of a semiconductor device of turn- off type as defined in the introduction, which may enable a reliable test of the function of such a semiconductor device without involving an unacceptably high degree of complexity and by that high costs.

SUMMARY OF THE INVENTION

The object of the present invention is to provide a test arrangement of the type defined in the introduction, which may be used for reliable tests of said semiconductor device of turn-off type under conditions similar to the conditions in said cascaded multi-level converter for which the semiconductor device is intended, in which the test arrangement shall be substantially less complicated and costly than the cascaded multi-level converter itself.
This object is according to the invention obtained by an arrangement and a method according to the independent claims.
The test arrangement according to the invention comprises a so-called back-to-back circuit having two phase legs, where each phase leg comprises

■ a series connection of at least two switching cells, with each switching cell comprising at least one energy storing capacitor and at least two semiconductor assemblies connected in series, each of the semiconductor assemblies having one of said semiconductor devices of turn-off type and a free-wheeling diode connected in anti-parallel therewith, and
■ inductance means with an inductance of substantially the same magnitude as that of an inductance means in a phase leg of the cascaded multi-level converter, and
■ a mid point in-between the at least two switching cells, where the back-to-back circuit further comprises at least one capacitor being arranged in an interconnection between the mid points of the two phase legs, and where the arrangement further comprises control means configured to control the semiconductor devices of the switching cells so as to obtain a determined alternating voltage on said mid points and measuring means for measuring the current through at least one of said phase legs upon such control.

Thus, the present inventor has understood that a so- called single phase back- to- back circuit with switching cells being similar to that of the cascaded multi-level converter and with a semiconductor device to be tested built in therein may be used for testing the proper function of the semiconductor device. However, a cascaded multi- level converter normally contains a considerable number of said switching cells connected in series, normally eight or sixteen. The present inventor has realized that it would be difficult to make realistic tests with a back- to- back circuit which is based on exactly the same structure of switching cells as in the relevant cascaded multi- level converter, since this would involve many semiconductor devices and anti- parallel diodes leading to high ripple currents during the testing. However, the present inventor realized further that it is in fact possible to reduce the number of switching cells connected in series in such a test arrangement comprising a back- to- back circuit in the case that at least one capacitor is arranged in the interconnection of the midpoints of the two phase legs of the back- to- back circuit. This makes it possible to over- dimension the inductance means if the test arrangement with respect to the number of switching cells in the phase legs of the test arrangement, so that each of the two phase legs of the arrangement has inductance means with an inductance of substantially the same magnitude as that of the inductance means in a phase leg of said cascaded multi- level converter. The ripple current generated by the semiconductor devices and the diode currents of the switching cells is thereby reduced. Solely over- dimensioning the inductance means in this way would result in a too high fundamental frequency impedance of the phase legs of the test arrangement, so that the current would be insufficiently low for carrying out proper tests, but the arrangement of a suitable capacitance in said interconnection makes it possible to compensate the over- dimensioning of the inductance means, so that the fundamental frequency impedance is reduced to a suitable level and by that currents suitable for carrying out said testing are obtained. This means that a test arrangement for testing the proper function of the semiconductor devices of a cascaded multi- level converter can be provided at an acceptably low cost. The inventor found out that the number switching cells per phase leg can be reduced to a minimum of two, which results in a very simplified test arrangement, which is able to still deliver excellent, reliable test results.
According to a preferred embodiment, the switching cells of the test arrangement are the same as are used in the cascaded multi-level converter, i.e. not only each semiconductor device of the converter can be tested piece for piece and afterwards built into a switching cell, but each switching cell may be tested as a component group.
According to an embodiment of the invention the inductance means of the arrangement has an inductance being 50-120%, in particular 70-100%, of the inductance of said inductance means of a phase leg of the cascaded multi-level converter. It has turned out that it is well possible to use the same inductance means in said test arrangement as the inductance means used in the cascaded multi-level converter for which the semiconductor device to be tested is intended to be used thanks to the arrangement of said at least one capacitor in said interconnection for reducing the ripple currents to a level being comparable with the level thereof in said cascaded multi-level converter. However, this inductance means may be selected to be slightly different should that for any reason be convenient.
According to another embodiment of the invention the capacitance of said at least one capacitor connecting said two mid points is adapted to the inductance of said inductance means of the arrangement so as to have a fundamental frequency impedance of said phase legs of the arrangement being on the same level as the fundamental frequency impedance of a phase leg of a said cascaded multi-level converter for which the semiconductor device is designed, such as being 50-150%, especially 80-120% thereof. This makes it possible to upon said control of the semiconductor devices of the switching cells obtain a suitable current to be measured by said measuring means.

According to another embodiment of the invention a capacitance C is calculated according to the formula

$$C = \frac{(n - m)}{n \cdot \omega^2 \cdot L},$$

in which n is the number of switching cells intended to be connected in series between a pole and a mid point in a phase leg of said cascaded multi-level converter, m equals half the number of switching cells connected in series in a phase leg of the arrangement, L equals half the inductance of the inductance means of a phase leg in said cascaded multi-level converter and $2\pi\omega$ is the fundamental frequency of said control, and in that said capacitance of said at least one capacitor between said two midpoints is selected to be 80-120% of C. A capacitance calculated according to this formula will result in a fundamental frequency impedance of a phase leg of the test arrangement being the same as that of a phase leg of said cascaded multi-level converter, which is suitable.

According to another embodiment of the invention, the number of switching cells connected in series in a phase leg of said arrangement is less or equal to half of the number of switching cells intended to be connected in series in a phase leg of said cascaded multi-level converter. This results in a test arrangement being considerably simplified with respect to a complete single phase back-to-back circuit, and according to another embodiment of the invention, the number of switching cells connected in series in a phase leg of said arrangement is less or equal to a quarter, in particular less or equal to a sixth part, of the number of switching cells intended to be connected in series in a phase leg of said cascaded multi-level converter.

According to another embodiment of the invention the arrangement comprises switching cells having each more than two semiconductor devices, such as 4 to 25, especially 6 to 18. Such a high number of semiconductor devices connected in series in such a switching cell is suitable for a cascaded multi-level converter for high power application, and a test arrangement according to the present invention is particularly interesting for testing such switching cells, since said ripple currents will require a high number of switching cells connected in series should a normal single phase back-to-back circuit be used for the testing.

According to another embodiment of the invention the arrangement comprises switching cells in which said semiconductor devices are IGBTs (Insulated Gate Bipolar Transistor), IGCTs (Integrated Gate Commutated Thyristor) or GTOs (Gate Turn-Off thyristor). The proper function of these semiconductor devices may be reliably tested by the test arrangement according to the invention.

According to another embodiment of the invention the arrangement is configured to have a voltage across said at least one energy storing capacitor of 5 kV - 50 kV, especially 10 kV - 25 kV, when being a component of said cascaded multi-level converter. Such high voltages across said energy storing capacitor normally mean a comparatively high number of semiconductor devices connected in series in said switching cell, which makes a test arrangement according to the present invention especially preferred (see above).

According to another embodiment of the invention the arrangement is configured to test the semiconductor device which is configured to be arranged in a cascaded multi-level HVDC converter suitable for a direct voltage larger than 1 kV, preferably larger than 10 kV and most preferably larger than 100 kV. The invention is the more interesting the higher said direct voltage for a said cascaded multi-level converter is.

According to another embodiment of the invention the arrangement, one or more of said semiconductor devices in said switching cells are already tested so as to test the function of the remaining semiconductor device or devices. In a further embodiment, one or more of said switching cells are already tested so as to test the function of the remaining switching cell or switching cells. Accordingly, it is possible to build in semiconductor devices and/or switching cells coming from the production line in all possible places of the test arrangement, but it is also possible to have one or more of said semiconductor devices and/or switching cells of the test arrangement constituted by semiconductor devices and switching cells, respectively, which were already tested so as to test the function of the remaining of the semiconductor devices and switching cells, respectively. This remaining number can be reduced to only one said semiconductor device or switching cell to be tested, where all the others are known to function properly.

The invention also relates to a method for testing the function of a semiconductor device of turn-off type configured to be a component of a cascaded multi-level converter, where said semiconductor device is built in as one of the semiconductor devices in a test arrangement according to any of the embodiments described above. The semiconductor devices in the test arrangement are according to the invention controlled so as to obtain a determined alternating voltage on the mid points of the phase legs of the test arrangement. The current through said phase legs is measured during the control of the semiconductor devices and compared with a current to be expected in said cascaded multi-level converter. The advantages of such a method appear clearly from the above discussion of the different embodiments of the arrangement according to the present invention.

Further advantages as well as advantageous features of the invention will appear from the following description.

BRIEF DESCRIPTION OF THE DRAWINGS

With reference to the appended drawings, below follows a specific description of embodiments of the invention cited as examples.

In the drawings:

Fig 1      is a very simplified view of a cascaded multi-level converter of the type having switching cells to be tested by a test arrangement according to the invention,

Fig 2      is a simplified view very schematically illustrating a single phase back-to-back circuit principally possible to be used as a said test arrangement,

Fig 3      is a view corresponding to Fig 2 of a test arrangement according to the first embodiment of the invention,

Fig 4      is a view corresponding to Fig 2 of a test arrangement according to a second embodiment of the invention being slightly modified with respect to the test arrangement shown in Fig 3, and

Fig 5      is a graph showing the current through said phase legs of an arrangement according to Fig 3 versus time according to a simulation of a procedure of testing the function of a switching cell thereof.

DETAILED DESCRIPTION OF EMBODIMENTS OF THE INVENTION

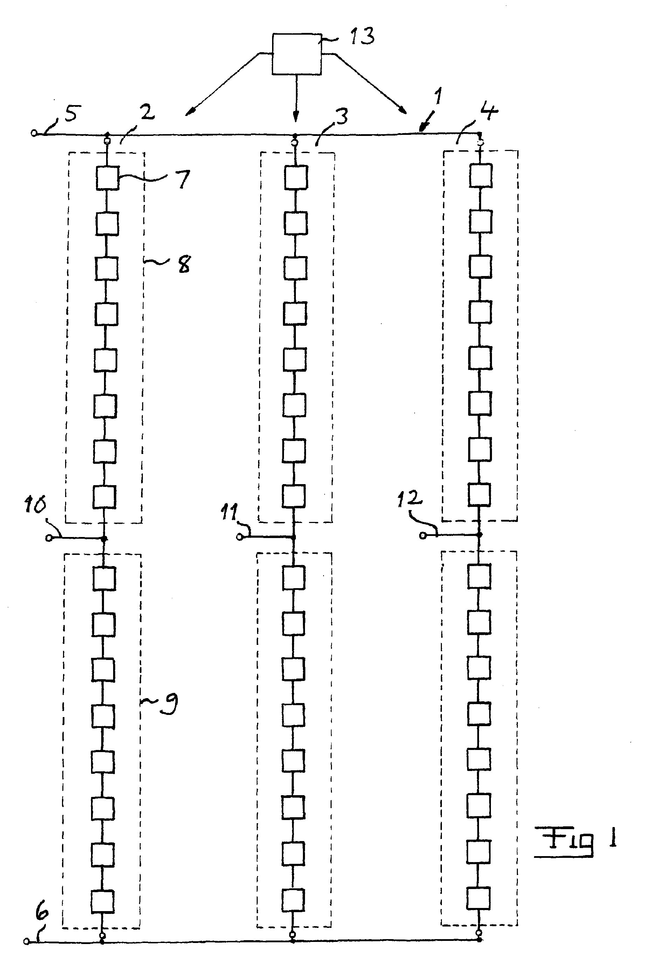

Fig 1 illustrates very schematically the general construction of a cascaded multi-level converter 1 having switching cells 7 which each comprise semiconductor devices the function of which is to be tested by a test arrangement according to the present invention. The converter 1 has three phase legs 2-4 connected to opposite poles 5, 6 of a direct voltage side of the converter, where the poles 5, 6 may belong to a direct voltage network for transmitting High Voltage Direct Current. Each phase leg 2-4 comprises a series connection of switching cells 7 indicated by boxes, in the present case 16 to the number, and this series connection is divided into two equal parts, a so called upper valve branch 8 and a lower valve branch 9, separated by a mid point 10-12, respectively, forming a phase output of the corresponding phase leg and being configured to be connected to an alternating voltage side of the converter. The phase outputs 10-12 may be connected to a three-phase alternating voltage network or a load, with possibly a transformer in between. Filtering equipment is also arranged on said alternating voltage side for improving the shape of the alternating voltage on said alternating voltage side.

A control means 13 is arranged for controlling the switching cells 7 and by that the converter to convert direct voltage into alternating voltage and conversely.

The cascaded multi-level converter 1 has switching cells 7, 7' of the following type: each switching cell 7, 7' comprises on one hand at least two semiconductor assemblies connected in series, where each semiconductor assembly contains a semiconductor device of turn-off type and a free-wheeling diode connected in anti-parallel therewith, and on the other hand at least one energy storing capacitor.

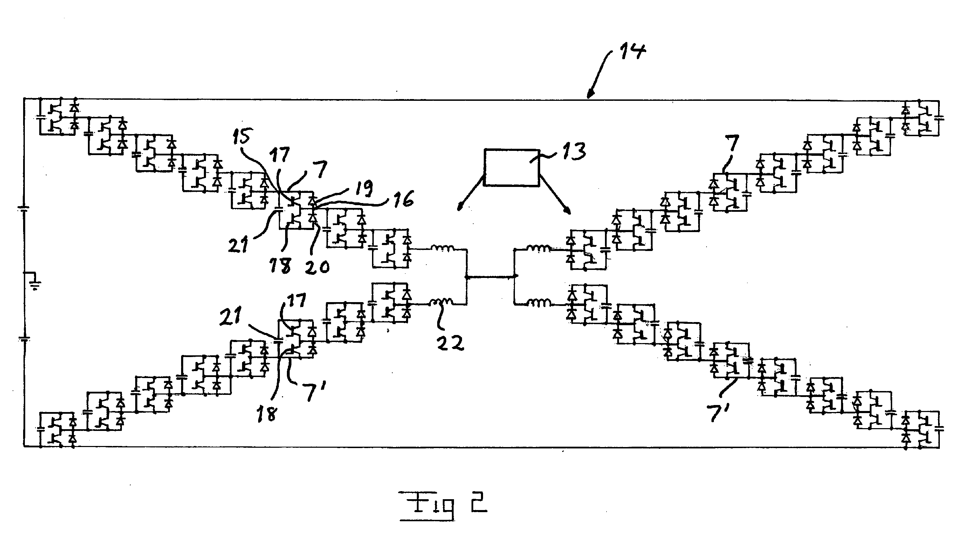

An example of such a switching cell is shown in Fig 2, which depicts a possible test arrangement for the semiconductor devices to used in a converter according to Fig 1. The test arrangement of Fig 2 is in the form of a single phase back-to-back circuit 14. This back-to-back circuit has on each direct voltage side thereof a phase leg with as many switching cells 7, 7' connected in series as are used in said cascaded multi-level converter 1 shown in Fig 1, i.e. 16.

The terminals 15, 16 of each switching cell 7, 7' are adapted to be connected to adjacent switching cells in the series connection of switching cells forming a phase leg. The semiconductor devices 17, 18 are in this case IGBTs connected in anti-parallel with diodes 19, 20. Although only one semiconductor device and one diode is shown per assembly these may stand for a number of semiconductor devices and diodes, respectively, connected in parallel for sharing the current flowing through the assembly, and in the case to be discussed below by way of example the number of IGBTs connected in series in each such switching cell 7, 7' is 16 and each IGBT is dimensioned for being able to block a voltage of 2.5 kV when turned off. An energy storing capacitor 21 is connected in parallel with the series connected semiconductor assemblies of each switching cell. Thus, each switching cell 7, 7' may have a voltage of 20 kV across said capacitor 21.

One terminal 15 of each switching cell 7, 7' is connected to the mid point between the two semiconductor assemblies of a first neighbouring switching cell. The other terminal 16 is connected to the energy storing capacitor 21 of a second neighbouring switching cell, in the embodiment 7 to a high voltage side of the capacitor and in the embodiment 7' to a low voltage side of the capacitor.

In the example shown in Fig 2, the semiconductor devices to be tested are the semiconductor devices 17, 18 where the reference signs point to, two of them in the upper and two of them in the lower part of the phase leg which is arranged to the left of the back-to-back circuit. The semiconductor devices 17, 18 of all switching cells 7 and 7' are controlled to obtain one of a) a first switching state and b) a second switching state of the corresponding cell, in which for a) the voltage across the capacitor 21 and for b) a zero voltage is applied across the terminals 15, 16. For obtaining the first state in a switching cell of type 7', the semiconductor device 17 is turned on and the semiconductor device 18 turned off, and in a switching cell of type 7, the semiconductor device 18 is turned on and the semiconductor device 17 is turned off. The switching cells are switched to the second state by changing the state of the semiconductor devices, so that in switching cells of type 7' the semiconductor device 17 is turned off and 18 turned on and in switching cells of type 7 the semiconductor device 18 is turned off and 17 is turned on.

The phase legs are provided with inductance means 22 in the form of so-called phase reactors, where each phase leg comprises two such phase reactors arranged in series connection and symmetrically to a midpoint of the phase leg. In the example here, each phase reactor has an inductance of around 5 mH for smoothing out the alternating current resulting from the control of the switching cells.

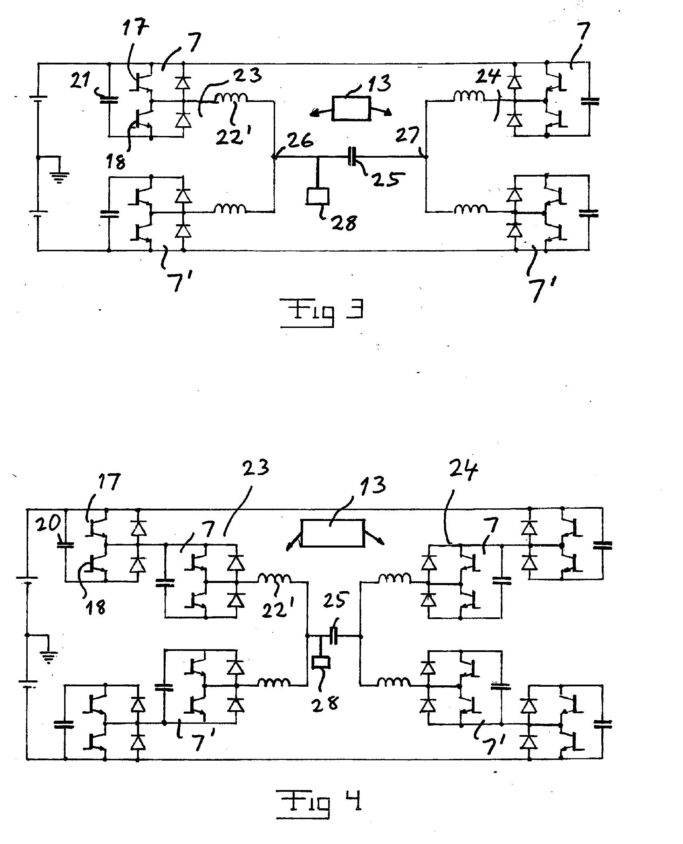

A test arrangement according to a first embodiment of the invention is shown in Fig 3, and this test arrangement is formed by a back-to-back circuit of the type shown in Fig 2 with only two switching cells per phase leg 23, 24. The inductance means 22' are here of the same size as for the circuit shown in Fig 2. The size of the inductance means 22' were chosen to be of approximately the same size as the phase reactors in the phase legs of the cascaded multi-level converter in which the semiconductor devices 17, 18 to be tested are to be built in. This means that the fundamental frequency impedance of the respective phase leg 23, 24 would normally be raised to a level which would result in a phase current being insufficient for carrying out the test. However, this problem is taken care of by arranging a capacitor 25 in the interconnection of the mid points 26, 27 of the two phase legs 23, 24. The capacitance of this capacitor 25 is determined in the following way. First, a capacitance C is calculated according to a formula

$$C = \frac{(n-m)}{n \cdot \omega^2 \cdot L},$$

in which n is the number of switching cells intended to be connected in series between a pole and a midpoint in a phase leg of said cascaded multi-level converter, m is half the number of switching cells connected in series in a phase leg of the test arrangement, L is the inductance of the inductance means 22', i.e. L is half the inductance of the inductance means of a phase leg in said cascaded multi-level converter, and $2\pi\omega$ is the fundamental frequency of the determined alternating voltage generated by above described control which in the present case of Figs 1 and 3 means that C = (8-1)/ (8 x $\omega^2$ x L) = 7/(8 x $\omega^2$ x L).

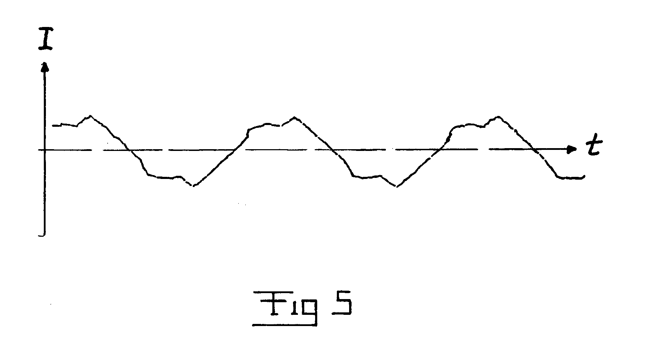

When using the test arrangement according to Fig 3 the semiconductor devices of the switching cells 7, 7' are controlled by said control means 13 according to a suitable control procedure for obtaining an alternating voltage at said mid points 26, 27, and the phase current is measured by a measuring means indicated with 28 which is arranged in series with the capacitor 25 in the interconnection between the midpoints 26 and 27. This phase current is then compared with a phase current expected should all the switching cells of the test arrangement operate as desired. Fig 5 illustrates the phase current I of the test arrangement according to Fig 3 versus time t according to a simulation. The shape of the current I indicates that the test arrangement according to Fig 3 is well suited for testing the function of the semiconductor devices and of the switching cells in question.

The test arrangement according to Fig 3 may be arranged so that three of the switching cells permanently belong to the test arrangement and a fourth switching cell is constituted by a switching cell to be tested, but it is also possible to use such a test arrangement for testing any other number of switching cells, such as 2, 3 or 4.

Fig 4 shows a test arrangement according to a second embodiment of the invention where the number of switching cells has been reduced to a quarter of the number of switching cells used in the circuit in Fig 2, i.e. four switching cells per phase leg. Compared to that, only one eighth of the switching cells is used in the test arrangement according to Fig 3, i.e. two switching cells per phase leg. A test arrangement according to Fig 4 results in a somewhat smoother shape of the phase current obtainable when controlling the semiconductor devices.

**Claims**

1. A test arrangement for testing the function of a semiconductor device of turn-off type configured to be a component of a cascaded multi-level converter (1), **characterized in that** the arrangement comprises a so-called back-to-back circuit (14) having two phase legs (23, 24), where each phase leg comprises

    • a series connection of at least two switching cells (7, 7'), with each switching cell comprising at least one energy storing capacitor (21) and at least two semiconductor assemblies connected in series, each of the semiconductor assemblies having one of said semiconductor devices (17, 18) of turn-off type and a free-wheeling diode (19, 20) connected in anti-parallel therewith, and

• inductance means (22') with an inductance of substantially the same magnitude as that of an inductance means in a phase leg of the cascaded multi-level converter, and

• a mid point (26, 27) in-between the at least two switching cells,

where the back-to-back circuit further comprises at least one capacitor (25) being arranged in an interconnection between the mid points (26, 27) of the two phase legs (23, 24), and where the arrangement further comprises control means (13) configured to control the semiconductor devices (17, 18) of the switching cells (7, 7') so as to obtain a determined alternating voltage on said mid points (26, 27) and measuring means (28) for measuring the current through at least one of said phase legs (23, 24) upon such control for being compared with a current to be expected in said cascaded multi-level converter.

2. An arrangement according to claim 1, where each switching cell is configured to be a switching cell of the cascaded multilevel converter.

3. An arrangement according to claim 1, further **characterized in that** (22') the inductance means (22') has an inductance being 50-120%, in particular 70-100%, of the inductance of said inductance means of a phase leg of the cascaded multi-level converter.

4. An arrangement according to claim 1 or 2, further **characterized in that** the capacitance of said at least one capacitor (25) between said two midpoints (26, 27) is adapted to the inductance of said inductance means (22') of the arrangement so that a fundamental frequency impedance of a phase leg of the arrangement is on the same level as the fundamental frequency impedance of a phase leg of a said cascaded multi-level converter, such as being 50-150%, especially 80-120% thereof.

5. An arrangement according to any of the preceding claims, further **characterized in that** a capacitance C is calculated according to the formula

$$ C = \frac{(n-m)}{n \cdot \omega^2 \cdot L}, $$

in which n is the number of switching cells (7, 7') intended to be connected in series between a pole and a mid point in a phase leg of said cascaded multi-level converter, m equals half the number of switching cells connected in series in a phase leg (23, 24) of the arrangement, L equals half the inductance (22') of the inductance means of a phase leg in said cascaded multi- level converter and 2 [pi] [omega] is the fundamental frequency of said control, and **in that** said capacitance of said at least one capacitor (25) between said two midpoints (26, 27) is selected to be 80- 120% of C.

6. An arrangement according to any of the preceding claims, further **characterized in that** the number of switching cells (7, 7') connected in series in a phase leg of said arrangement is less or equal to half of the number of switching cells intended to be connected in series in a phase leg of said cascaded multi-level converter.

7. An arrangement according to any of the preceding claims, further **characterized in that** the number of switching cells (7, 7') connected in series in a phase leg of said arrangement is less or equal to a quarter, in particular less or equal to a sixth part, of the number of switching cells intended to be connected in series in a phase leg of said cascaded multi-level converter.

8. An arrangement according to any of the preceding claims, further **characterized in that** it comprises switching cells (7, 7') having each more than two semiconductor devices (17, 18), such as 4 to 25, especially 6 to 18.

9. An arrangement according to any of the preceding claims, further **characterized in that** it comprises switching cells (7, 7') in which said semiconductor devices (17, 18) are IGBTs (Insulated Gate Bipolar Transistor), IGCTs (Integrated Gate Commutated Thyristor) or GTOs (Gate Turn-Off thyristor).

10. An arrangement according to any of the preceding claims 2-9, further **characterized in that** it is configured to have a voltage across said at least one energy storing capacitor (21) of 5 kV - 50 kV, especially 10 kV - 25 kV, when being a component of said cascaded multi-level converter.

11. An arrangement according to any of the preceding claims, further **characterized in that** it is configured to test the semiconductor device which is configured to be arranged in a cascaded multilevel HVDC converter suitable for a direct voltage larger than 1 kV, preferably larger than 10 kV and most preferably larger than 100 kV.

12. An arrangement according to any of the preceding claims, further **characterized in that** one or more of said semiconductor devices (17, 18) in said switching cells (7, 7') are already tested so as to test the function of the remaining semiconductor device or devices.

13. An arrangement according to any of the preceding claims 2-12, further **characterized in that** one or more of said switching cells (7, 7') are already tested so as to test the function of the remaining switching cell or switching cells.

14. A method for testing the function of a semiconductor device of turn-off type configured to be a component of a cascaded multi-level converter, **characterized in that** said semiconductor device is built in as one of the semiconductor devices (17, 18) in a test arrangement according to any of claims 1-13, where the semiconductor devices (17, 18) are controlled so as to obtain a determined alternating voltage on the mid points (26, 27) of the phase legs (23, 24) of the arrangement, and where the current through said phase legs is measured during the control of the semiconductor devices (17, 18) and compared with a current to be expected in said cascaded multi-level converter.

**Patentansprüche**

1. Testanordnung zum Testen der Funktion einer Halbleitervorrichtung vom Abschalttyp, die als eine Komponente eines kaskadierten Mehrstufenumsetzers (1) konfiguriert ist, **dadurch gekennzeichnet, dass** die Anordnung einen sogenannten Back- to- Back- Schaltkreis (14) umfasst, der zwei Phasenzweige (23, 24) aufweist, wobei jeder Phasenzweig Folgendes umfasst:

    • eine Reihenschaltung von wenigstens zwei Schaltzellen (7, 7'), wobei jede Schaltzelle wenigstens einen energiespeichernden Kondensator (21) und wenigstens zwei Halbleiteranordnungen, die in Reihe geschaltet sind, umfasst, wobei jede der Halbleiteranordnungen eine der zwei Halbleitervorrichtungen (17, 18) vom Abschalttyp und eine Freilaufdiode (19, 20), die damit antiparallel geschaltet ist, aufweist, und
    • Induktivitätsmittel (22') mit einer Induktivität von im Wesentlichen gleicher Größe wie die von Induktivitätsmitteln in einem Phasenzweig des kaskadierten Mehrstufenumsetzers, und
    • einen Mittelpunkt (26, 27) zwischen den wenigstens zwei Schaltzellen,
    wobei der Back- to- Back- Schaltkreis ferner wenigstens einen Kondensator (25) umfasst, der in einer Zusammenschaltung zwischen den Mittelpunkten (26, 27) der zwei Phasenzweige angeordnet ist, und wobei die Anordnung ferner Steuermittel (13), die konfiguriert sind, die Halbleitervorrichtungen (17, 18) der Schaltzellen (7, 7') zu steuern, um eine bestimmte Wechselspannung auf den Mittelpunkten (26, 27) zu erhalten, und Messmittel (28) zum Messen des Stroms durch wenigstens einen der Phasenzweige (23, 24) nach einer solchen Steuerung, um mit einem Strom verglichen zu werden, der in dem kaskadierten Mehrstufenumsetzer erwartet werden kann, umfasst.

2. Anordnung nach Anspruch 1, wobei jede Schaltzelle als eine Schaltzelle des kaskadierten Mehrstufenumsetzers konfiguriert ist.

3. Anordnung nach Anspruch 1, ferner **dadurch gekennzeichnet, dass** die Induktivitätsmittel (22') eine Induktivität aufweisen, die 50-120 %, insbesondere 70-100 %, der Induktivität der Induktivitätsmittel eines Phasenzweigs des kaskadierten Mehrstufenumsetzers ist.

4. Anordnung nach Anspruch 1 oder 2, ferner **dadurch gekennzeichnet, dass** die Kapazität des wenigstens einen Kondensators (25) zwischen den zwei Mittelpunkten (26, 27) an die Induktivität der Induktivitätsmittel (22') der Anordnung angepasst ist, so dass eine Grundfrequenzimpedanz eines Phasenzweigs der Anordnung auf der gleichen Höhe wie die Grundfrequenzimpedanz eines Phasenzweigs des kaskadierten Mehrstufenumsetzers ist, z. B. 50-150 %, insbesondere 80-120 %, hiervon ist.

5. Anordnung nach einem der vorhergehenden Ansprüche, ferner **dadurch gekennzeichnet, dass** eine Kapazität C gemäß der Formel

$$C \;=\; \frac{(n - m)}{n \cdot \omega^2 \cdot L}$$

berechnet wird, wobei n die Anzahl der Schaltzellen (7, 7') ist, die vorgesehen sind, zwischen einem Pol und einem Mittelpunkt in einem Phasenzweig des kaskadierten Mehrstufenumsetzers in Reihe geschaltet zu werden, m gleich der halben Anzahl von Schaltzellen ist, die in einem Phasenzweig (23, 24) der Anordnung in Reihe geschaltet sind, L gleich der halben Induktivität (22') der Induktivitätsmittel eines Phasenzweigs in dem kaskadierten Mehrstufenumsetzer ist und 2 [pi] [omega] die Grundfrequenz der Steuervorrichtung ist, und dadurch, dass die Kapazität des wenigstens einen Kondensators (25) zwischen den zwei Mittelpunkten (26, 27) so gewählt ist, dass sie 80- 120 % von C ist.

6. Anordnung nach einem der vorhergehenden Ansprüche, ferner **dadurch gekennzeichnet, dass** die Anzahl der Schaltzellen (7, 7'), die in einem Phasenzweig der Anordnung in Reihe geschaltet sind, kleiner oder gleich der Hälfte der Anzahl von Schaltzellen ist, die vorgesehen sind, in einem Phasenzweig des kaskadierten Mehrstufenumsetzers in Reihe geschaltet zu sein.

7. Anordnung nach einem der vorhergehenden Ansprüche, ferner **dadurch gekennzeichnet, dass** die Anzahl von Schaltzellen (7, 7'), die in einem Phasenzweig der Anordnung in Reihe geschaltet sind, kleiner oder gleich einem Viertel, insbesondere kleiner oder gleich einem Sechstel, der Anzahl von Schaltzellen ist, die vorgesehen sind, in einem Phasenzweig des kaskadierten Mehrstufenumsetzers in Reihe geschaltet zu sein.

8. Anordnung nach einem der vorhergehenden Ansprüche, ferner **dadurch gekennzeichnet, dass** sie Schaltzellen (7, 7') umfasst, von denen jede mehr als zwei Halbleitervorrichtungen (17, 18), wie z. B. 4 bis 25, insbesondere 6 bis 18, umfasst.

9. Anordnung nach einem der vorhergehenden Ansprüche, ferner **dadurch gekennzeichnet, dass** sie Schaltzellen (7, 7') umfasst, in denen die Halbleitervorrichtungen (17, 18) IGBTs (Bipolartransistor mit isoliertem Gate), IGCTs (kommutierter Thyristor mit integriertem Gate) oder GTOs (Abschaltthyristor) sind.

10. Anordnung nach einem der vorhergehenden Ansprüche 2-9, ferner **dadurch gekennzeichnet, dass** sie konfiguriert ist, über dem wenigstens einen energiespeichernden Kondensator (21) eine Spannung von 5 kV-50 kV, insbesondere 10 kV-25 kV, aufzuweisen wenn sie eine Komponente des kaskadierten Mehrstufenumsetzers ist.

11. Anordnung nach einem der vorhergehenden Ansprüche, ferner **dadurch gekennzeichnet, dass** sie konfiguriert ist, die Halbleitervorrichtung zu testen, die konfiguriert ist, in einem kaskadierten Mehrstufen-HVDC-Umsetzer angeordnet zu sein, der für eine Gleichspannung größer als 1 kV, vorzugsweise größer als 10 kV und am meisten bevorzugt größer als 100 kV, geeignet ist.

12. Anordnung nach einem der vorhergehenden Ansprüche, ferner **dadurch gekennzeichnet, dass** eine oder mehrere der Halbleitervorrichtungen (17, 18) in den Schaltzellen (7, 7') bereits getestet sind, um die Funktion der einen oder der mehreren verbleibenden Halbleitervorrichtungen zu testen.

13. Vorrichtung nach einem der vorhergehenden Ansprüche 1-12, ferner **dadurch gekennzeichnet, dass** eine oder mehrere der Schaltzellen (7, 7') bereits getestet sind, um die Funktion der einen oder der mehreren verbleibenden Schaltzellen zu testen.

14. Verfahren zum Testen der Funktion einer Halbleitervorrichtung vom Abschalttyp, die als eine Komponente eines kaskadierten Mehrstufenumsetzers konfiguriert ist, **dadurch gekennzeichnet, dass** die Halbleitervorrichtung als eine der Halbleitervorrichtungen (17, 18) in einer Testanordnung nach einem der Ansprüche 1-13 eingebaut ist, wobei die Halbleitervorrichtungen (17, 18) gesteuert werden, um eine bestimmte Wechselspannung an den Mittelpunkten (26, 27) der Phasenzweige (23, 24) der Anordnung zu erreichen, und wobei der Strom durch die Phasenzweige während des Steuerns der Halbleitervorrichtungen (17, 18) gemessen und mit einem Strom verglichen wird, der in dem kaskadierten Mehrstufenumsetzers erwartet werden kann.

## Revendications

1. Agencement de test pour tester le fonctionnement d'un dispositif à semi-conducteur de type blocable conçu pour former un composant d'un convertisseur multiniveau en cascade (1), **caractérisé** **en ce qu'**il comprend un circuit dit dos-à-dos (14) comportant deux branches de phase (23, 24), chaque branche de phase comprenant

   • un montage en série d'au moins deux cellules de commutation (7, 7'), chaque cellule de commutation comprenant au moins un condensateur de stockage d'énergie (21) et au moins deux ensembles à semi-conducteur montés en série, chacun des ensembles à semi-conducteur comportant l'un desdits dispositifs à semi-conducteur (17, 18) de type blocable et une diode de roue libre (19, 20) montée tête-bêche avec lui, et
   • un moyen à inductance (22') présentant une inductance d'une grandeur sensiblement identique à celle d'un moyen à inductance dans une branche de phase du convertisseur multiniveau en cascade, et
   • un point milieu (26, 27) entre lesdites au moins deux cellules de commutation,
   lequel circuit dos-à-dos comprend en outre au moins un condensateur (25) agencé en interconnexion entre les points milieux (26, 27) des deux branches de phase (23, 24), et lequel agencement comprend en outre un moyen de commande (13) conçu pour commander les dispositifs à semi-conducteur (17, 18) des cellules de commutation (7, 7') de manière à obtenir une tension alternative déterminée sur lesdits points milieux (26, 27) et un moyen de mesure (28) pour mesurer le courant circulant dans au moins une desdites branches de phase (23, 24) lors de cette commande dans le but de le comparer à un courant escompté dans ledit convertisseur multiniveau en cascade.

2. Agencement selon la revendication 1, dans lequel chaque cellule de commutation est conçue pour former une cellule de commutation du convertisseur multiniveau en cascade.

3. Agencement selon la revendication 1, **caractérisé en outre en ce que** le moyen à inductance (22') présente une inductance représentant de 50 à 120%, plus particulièrement de 70 à 100%, de l'inductance dudit moyen à inductance d'une branche de phase du convertisseur multiniveau en cascade.

4. Agencement selon la revendication 1 ou 2, **caractérisé en outre en ce que** la capacité dudit au moins un condensateur (25) entre lesdits deux points milieux (26, 27) est adaptée à l'inductance dudit moyen à inductance (22') de l'agencement pour faire en sorte qu'une impédance à la fréquence fondamentale d'une branche de phase de l'agencement se situe au même niveau que l'impédance à la fréquence fondamentale d'une branche de phase dudit convertisseur multiniveau en cascade, en représentant notamment de 50 à 150% de celle-ci, plus particulièrement de 80 à 120% de celle-ci.

5. Agencement selon l'une quelconque des revendications précédentes, **caractérisé en outre en ce qu'**une capacité C est calculée selon la formule

$$C = \frac{(n - m)}{n \cdot \omega^2 \cdot L},$$

dans laquelle n est le nombre de cellules de commutation (7, 7') destinées à être montées en série entre un pôle et un point milieu dans une branche de phase dudit convertisseur multiniveau en cascade, m est égal à la moitié du nombre de cellules de commutation montées en série dans une branche de phase (23, 24) de l'agencement, L est égal à la moitié de l'inductance (22') du moyen à inductance d'une branche de phase dans ledit convertisseur multiniveau en cascade et 2 [pi] [oméga] est la fréquence fondamentale de ladite commande, et **en ce que** ladite capacité dudit au moins un condensateur (25) entre lesdits deux points milieux (26, 27) est choisie de manière à représenter de 80 à 120% de C.

6. Agencement selon l'une quelconque des revendications précédentes, **caractérisé en outre en ce que** le nombre de cellules de commutation (7, 7') montées en série dans une branche de phase dudit agencement est inférieur ou égal à la moitié du nombre de cellules de commutation destinées à être montées en série dans une branche de phase dudit convertisseur multiniveau en cascade.

7. Agencement selon l'une quelconque des revendications précédentes, **caractérisé en outre en ce que** le nombre de cellules de commutation (7, 7') montées en série dans une branche de phase dudit agencement est inférieur ou égal au quart, plus particulièrement inférieur ou égal au sixième, du nombre de cellules de commutation destinées à être montées en série dans une branche de phase dudit convertisseur multiniveau en cascade.

8. Agencement selon l'une quelconque des revendications précédentes, **caractérisé en outre en ce qu'**il comprend des cellules de commutation (7, 7') comportant chacune plus de deux dispositifs à semi-conducteur (17, 18), notamment de 4 à 25, plus particulièrement de 6 à 18.

9. Agencement selon l'une quelconque des revendications précédentes, **caractérisé en outre en ce qu'**il comprend des cellules de commutation (7, 7') dans lesquelles lesdits dispositifs à semi-conducteur (17, 18) sont des IGBT (transistors bipolaires à grille isolée), des IGCT (thyristors intégrés commutés par la gâchette) ou des GTO (thyristors blocables par la gâchette).

10. Agencement selon l'une quelconque des revendications 2 à 9 précédentes, **caractérisé en outre en ce qu'**il est conçu pour présenter une tension aux bornes dudit au moins condensateur de stockage d'énergie (21) comprise entre 5 kV et 50 kV, plus particulièrement entre 10 kV et 25 kV, lorsqu'il forme un composant dudit convertisseur multiniveau en cascade.

11. Agencement selon l'une quelconque des revendications précédentes, **caractérisé en outre en ce qu'**il est conçu pour tester le dispositif à semi-conducteur conçu pour être agencé dans un convertisseur à courant continu à haute tension (HVDC) multiniveau en cascade convenant à une tension continue supérieure à 1 kV, de préférence supérieure à 10 kV et mieux encore supérieure à 100 kV.

12. Agencement selon l'une quelconque des revendications précédentes, **caractérisé en outre en ce qu'**au moins un desdits dispositifs à semi-conducteur (17, 18) dans lesdites cellules de commutation (7, 7') a déjà subi un test pour permettre de tester le fonctionnement du (des) dispositif(s) à semi-conducteur restant(s).

**13.** Agencement selon l'une quelconque des revendications 2 à 12 précédentes, <u>**caractérisé**</u> **en outre en ce qu'**au moins une desdites cellules de commutation (7, 7') a déjà subi un test pour permettre de tester le fonctionnement de la (des) cellule(s) de commutation restante(s).

**14.** Procédé pour tester le fonctionnement d'un dispositif à semi-conducteur de type blocable conçu pour former un composant d'un convertisseur multiniveau en cascade, <u>**caractérisé**</u> **en ce que** ledit dispositif à semi-conducteur est intégré comme l'un des dispositifs à semi-conducteur (17, 18) dans un agencement de test selon l'une quelconque des revendications 1 à 13, le procédé consistant à commander les dispositifs à semi-conducteur (17, 18) de manière à obtenir une tension alternative déterminée sur les points milieux (26, 27) des branches de phase (23, 24) de l'agencement, et à mesurer le courant circulant dans lesdites branches de phase au cours de la commande des dispositifs à semi-conducteur (17, 18) et à le comparer à un courant escompté dans ledit convertisseur multiniveau en cascade.

Fig 1

Fig 2

EP 2 443 468 B1

Fig 3

Fig 4

Fig 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 10103031 A1

- WO 2007023064 A1